# EUROPEAN PATENT APPLICATION

(11) **EP 4 693 726 A1**
(43) Date of publication of application: **11.02.2026**
(21) Application number: 24791844.4
(22) Date of filing: 30.03.2024
(51) Int. Cl.: H01P 1/203

(54) **FILTERING APPARATUS, COMBINING APPARATUS, ANTENNA AND BASE STATION**

(30) Priority: 21.04.2023 CN 202310460103
(71) Applicant: Huawei Technologies Co., Ltd., Shenzhen, Guangdong 518129 (CN)
(72) Inventor: DENG, Liangyong, Shenzhen, Guangdong 518129 (CN); CAI, Dantao, Shenzhen, Guangdong 518129 (CN); XIAO, Weihong, Shenzhen, Guangdong 518129 (CN); JIN, Rui, Shenzhen, Guangdong 518129 (CN); FU, Jicheng, Shenzhen, Guangdong 518129 (CN)
(74) Representative: Maiwald GmbH
(86) International application number: PCT/CN2024/085112
(87) International publication number: WO 2024/217258

(57) **Abstract**

This application provides a filtering apparatus, a combining apparatus, an antenna, and a base station. The filtering apparatus includes a first filtering unit circuit. The first filtering unit circuit includes a first metal wire and a second metal wire. The first metal wire includes a first coupling region, a first connecting region, and a second coupling region that are connected in sequence. The second metal wire includes a third coupling region, a second connecting region, and a fourth coupling region that are connected in sequence. An orthographic projection of the first coupling region on a plane on which a surface of the third coupling region is located is at least partially located on the surface of the third coupling region, and the first coupling region is coupled to the third coupling region. An orthographic projection of the second coupling region on a plane on which a surface of the fourth coupling region is located is at least partially located on the surface of the fourth coupling region, and the second coupling region is coupled to the fourth coupling region. The first coupling region is directly electrically connected to the fourth coupling region. According to this solution, a volume of the filtering apparatus is reduced, and working efficiency of the filtering apparatus is improved.

## Description

### CROSS-REFERENCE TO RELATED APPLICATIONS

This application claims priority to Chinese Patent Application No. 202310460103.5, filed with the China National Intellectual Property Administration on April 21, 2023 and entitled "FILTERING APPARATUS, COMBINING APPARATUS, ANTENNA, AND BASE STATION", which is incorporated herein by reference in its entirety.

### TECHNICAL FIELD

This application relates to the field of electronic device technologies, and in particular, to a filtering apparatus, a combining apparatus, an antenna, and a base station.

### BACKGROUND

In a wireless communication system, a filtering apparatus can better implement the passing of wanted signals and attenuate unwanted signals. Signals in wireless communication usually include an interference signal. For this reason, a filtering apparatus is disposed in an antenna communication system, so that a signal within an operating frequency band of an antenna can be transmitted through the filtering apparatus to implement communication; and the interference signal is attenuated to reduce interference to the antenna signal. As an integration level of a wireless device is increasingly high, a requirement for miniaturization and lightweight of a filtering apparatus is increasingly high.

In addition, a filtering apparatus in a conventional technology usually has a relatively large quantity of accessories, which causes a relatively large quantity of intermodulation points of the filtering apparatus, and causes relatively large interference to a signal.

### SUMMARY

This application provides a filtering apparatus, a combining apparatus, an antenna, and a base station, to reduce a volume of the filtering apparatus and improve working efficiency of the filtering apparatus.

According to a first aspect, this application provides a filtering apparatus. The filtering apparatus includes a first filtering unit circuit and a support mechanical part. The first filtering unit circuit is disposed on the support mechanical part, and the support mechanical part is configured to support the first filtering unit circuit and mount the first filtering unit circuit to a specified position. Specifically, the first filtering unit circuit includes a first metal wire and a second metal wire. The first metal wire includes a first coupling region, a second coupling region, and a first connecting region. The first connecting region is connected between the first coupling region and the second coupling region. In other words, the first coupling region, the first connecting region, and the second connecting region are connected in sequence. The second metal wire includes a third coupling region, a fourth coupling region, and a second connecting region. The second connecting region is connected between the third coupling region and the fourth coupling region. In other words, the third coupling region, the second connecting region, and the fourth coupling region are connected in sequence. An orthographic projection of the first coupling region on a plane on which a surface of the third coupling region is located is at least partially located on the surface of the third coupling region, the first coupling region and the third coupling region are stacked and spaced by a first preset size, and the first coupling region and the third coupling region are coupled; an orthographic projection of the second coupling region on a plane on which a surface of the fourth coupling region is located is at least partially located on the surface of the fourth coupling region, the second coupling region and the fourth coupling region are stacked and spaced by a preset size, and the second coupling region and the fourth coupling region are coupled; and the first coupling region is directly electrically connected to the fourth coupling region. The filtering apparatus in this solution has a relatively simple structure and a relatively small size, which is conducive to miniaturization and low costs of the filtering apparatus. In addition, the filtering apparatus has a relatively small quantity of accessories, and the filtering apparatus has a relatively small quantity of intermodulation points, so that interference to a signal is relatively small, which helps improve working efficiency of the filtering apparatus.

The filtering apparatus may further include a housing, where the housing is a housing of an integrated structure. The housing has an inner cavity and an opening in communication with the inner cavity. A groove is disposed in the inner cavity of the housing, the groove extends towards the opening, and the support mechanical part is inserted into the groove. Because the housing is of an integrated structure, the structure of the filtering apparatus is relatively simple, a quantity of accessories of the filtering apparatus is relatively small, a quantity of intermodulation points of the filtering apparatus is also relatively small, and interference to a signal is relatively small, which helps improve working efficiency of the filtering apparatus. In addition, a mounting process of the support mechanical part is relatively simple.

The housing may be a metal housing, and the metal housing may be used as a reference ground of the first filtering unit.

In a possible implementation, the support mechanical part is a dielectric substrate, and the first filtering unit circuit is formed on the dielectric substrate. Specifically, the first filtering unit circuit is formed on a surface of the dielectric substrate or at a different layer. In this case, it may be considered that an orthographic projection of the first coupling region on a plane on which the dielectric substrate is located at least partially overlaps an orthographic projection of the third coupling region on the plane on which the dielectric substrate is located, and an orthographic projection of the second coupling region on the plane on which the dielectric substrate is located at least partially overlaps an orthographic projection of the fourth coupling region on the plane on which the dielectric substrate is located.

When the support mechanical part is the dielectric substrate, a metal layer may be further formed on a surface of the dielectric substrate. The metal layer avoids the first metal wire and the second metal wire. In other words, the metal layer avoids the first filtering unit circuit, so that the metal layer is disconnected from the first metal wire and the second metal wire. Specifically, the metal layer and the first metal wire may be disposed at a same layer; or the metal layer and the second metal wire may be disposed at a same layer; or two metal layers may be formed on the dielectric substrate, and the two metal layers are respectively disposed at the same layers as the first metal wire and the second metal wire, to simplify a preparation process of the filtering apparatus. The foregoing metal layer may be used as a reference ground of the filtering apparatus, and a structure of the reference ground of the filter in this embodiment is simple. In addition, the filtering apparatus may not be provided with a housing as a reference ground, thereby further reducing a volume of the filtering apparatus.

In a possible implementation, the filtering apparatus includes one first filtering unit and two transmission ports. The two transmission ports are a first transmission port and a second transmission port, and are configured to connect to external devices. A first metal wire of the first filtering unit is connected to the first transmission port, and a second metal wire of the first filtering unit is connected to the second transmission port. The first transmission port and the second transmission port are configured to connect to external devices. In this solution, filtering may be performed in a form of cascading and self-coupling of metal wires, and an in-band dual-pole and out-of-band dual-zero band-stop filtering effect can be implemented. The filtering apparatus has a smaller volume compared with a filtering apparatus with an equivalent function.

Specifically, in a process of forming the first metal wire and the second metal wire, the first coupling region, the second coupling region, the third coupling region, and the fourth coupling region are sheet-shaped, and the first connector and the second connecting region are line-shaped. In this solution, the coupling region and the connecting region have different width sizes. Impedance of the first coupling region, the second coupling region, the third coupling region, and the fourth coupling region that are sheet-shaped is low, and impedance of the first connector and the second connecting region that are line-shaped is high. This solution uses a form of cascading and self-coupling of double high&low metal wires, and achieves an in-band double-pole and out-of-band double-zero band-stop filtering effect. In addition, the first coupling region, the second coupling region, the third coupling region, and the fourth coupling region that are sheet-shaped have a relatively large coupling area and a good coupling effect, so that the volume of the filtering apparatus can be relatively small.

When the foregoing coupling regions are being specifically formed, a shape of each coupling region is not limited. Specifically, a shape of the orthographic projection of the first coupling region on the plane on which the surface of the third coupling region is located may be the same as a shape of the surface of the third coupling region, and a shape of the orthographic projection of the second coupling region on the plane on which the surface of the fourth coupling region is located may be the same as a shape of the surface of the fourth coupling region. Specifically, in a process of forming the first metal wire and the second metal wire on the dielectric substrate, a shape of a surface that is of the first coupling region and that faces the third coupling region is the same as a shape of a surface that is of the third coupling region and that faces the first coupling region, and a shape of a surface that is of the second coupling region and that faces the fourth coupling region is the same as a shape of a surface that is of the fourth coupling region and that faces the second coupling region. In this way, when the first coupling region is coupled to the third coupling region, a coupling area of the first coupling region and the third coupling region may be an area of the foregoing surface of the first coupling region. Similarly, when the second coupling region is coupled to the fourth coupling region, a coupling area of the second coupling region and the fourth coupling region may be an area of the foregoing surface of the second coupling region. This solution helps fully couple the first coupling region and the third coupling region and fully utilize the areas of the first coupling region and the third coupling region. Similarly, this also helps fully couple the second coupling region and the fourth coupling region and fully utilize the areas of the second coupling region and the fourth coupling region.

Specifically, shapes of surfaces of the first coupling region, the second coupling region, the third coupling region, and the fourth coupling region may be regular shapes such as squares or circles, which are convenient for preparation and simulation analysis, so as to determine an operating frequency band.

In addition, to increase the coupling area, the orthographic projection of the first coupling region on the plane on which the surface of the third coupling region is located may be completely located on the surface of the third coupling region. In this way, the coupling area of the first coupling region and the third coupling region is an area of the first coupling region, and a size of the first coupling region is fully used. The orthographic projection of the second coupling region on the plane on which the surface of the fourth coupling region is located is completely located on the surface of the fourth coupling region. In this way, the coupling area of the second coupling region and the fourth coupling region is an area of the second coupling region, and a size of the second coupling region is fully used.

To enrich functions of the filtering apparatus, the filtering apparatus may further include a second filtering unit circuit. The second filtering unit circuit also includes two metal wires: a third metal wire and a fourth metal wire. Specifically, the third metal wire includes a fifth coupling region and a third connecting region that are connected, and the fourth metal wire includes a sixth coupling region and a fourth connecting region that are connected. The second filtering unit circuit is similar to the third unit circuit. An orthographic projection of the fifth coupling region on a plane on which a surface of the sixth coupling region is located is at least partially located on the surface of the sixth coupling region, and the fifth coupling region is coupled to the sixth coupling region. One end that is of the third connecting region and that is away from the fifth coupling region is directly electrically connected to one end that is of the fourth connecting region and that is away from the sixth coupling region, and the third metal wire is directly electrically connected to the second metal wire, so that the first filtering unit circuit is electrically connected to the second filtering unit circuit, to form an overall structure and work cooperatively. The filtering apparatus performs filtering in a form of cascading and self-coupling of metal wires, can implement an in-band three-pole and out-of-band three-zero band-stop filtering effect, and has a smaller volume compared with a filtering apparatus with an equivalent function.

In addition to the foregoing embodiment, the filtering apparatus may further include at least two first filtering unit circuits, and the at least two first filtering unit circuits are electrically connected to form an overall structure, so as to work cooperatively. Specifically, first metal wires of two adjacent first filtering unit circuits are directly electrically connected, or second metal wires of two adjacent filtering unit circuits are directly electrically connected. For example, if first metal wires in two adjacent first filtering unit circuits are relatively close to each other, the first metal wires in the two adjacent first filtering unit circuits may be directly electrically connected. If second metal wires in two adjacent first filtering unit circuits are relatively close to each other, the second metal wires in the two adjacent first filtering unit circuits may be directly electrically connected. When three first filtering unit circuits that are sequentially connected are interconnected, one side of a first filtering unit circuit located in the middle is directly electrically connected, through a first metal wire, to a first metal wire of a first filtering unit circuit adjacent to this side; and the other side is directly electrically connected, through a second metal wire, to a second metal wire of a first filtering unit circuit adjacent to this side. In conclusion, for each first filtering unit circuit, one of the first metal wire and the second metal wire inputs a signal and the other outputs a signal, and it may be considered that a plurality of first filtering unit circuits are connected in series to perform filtering cooperatively. The filtering apparatus in this solution can perform multi-order filtering, and has a simple structure and a small volume.

According to a second aspect, this application provides a combining apparatus. The combining apparatus includes one first general transmission port, at least two second general transmission ports, and at least two filtering apparatuses according to the first aspect. Second metal wires of the at least two filtering apparatuses are electrically connected to a same first general transmission port, and a first metal wire of each filtering apparatus is electrically connected to one second general transmission port. It may be considered that the at least two filtering apparatuses are disposed in parallel. The combining apparatus in this solution may combine a plurality of channels of signals into one channel of signals for transmission, and may filter the plurality of channels of signals to remove an interference signal. Because the filtering apparatus has a simple structure and a small volume, the combining apparatus also has a simple structure and a small volume.

In a scenario in which a signal is input from the second general transmission port and output from the first general transmission port, the combining apparatus is used as a combiner. When a signal is transmitted in a reverse direction, that is, the signal is input from the first general transmission port and output from the second general transmission port, the foregoing combining apparatus is used as a splitter.

According to a third aspect, this application provides an antenna, where the antenna includes a radiating element and the filtering apparatus according to the first aspect. The filtering apparatus is electrically connected to the radiating element, and the filtering apparatus is configured to filter a signal transmitted by the radiating element. This solution helps improve a filtering effect, and can reduce a volume of the antenna.

According to a fourth aspect, this application further provides another antenna, where the antenna includes a radiating element and the combining apparatus according to the second aspect. The combining apparatus is electrically connected to the radiating element, and is configured to combine signals of different frequencies into one channel of signals. This solution helps reduce a volume of the antenna.

According to a fifth aspect, this application provides a base station, where the base station includes a mounting bracket and the antenna according to the third aspect or the antenna according to the fourth aspect, and the antenna is mounted on the mounting bracket. This solution helps improve a working effect of the base station. Because the volume of the antenna is relatively small, this solution further improves an integration level of the base station.

### BRIEF DESCRIPTION OF DRAWINGS

FIG. 1 is a diagram of an architecture of a communication system to which an embodiment of this application is applicable;
FIG. 2 is a diagram of a possible structure of a base station according to an embodiment of this application;
FIG. 3 is a diagram of a possible composition of an antenna according to an embodiment of this application;
FIG. 4 is a diagram of a structure of a combining apparatus according to an embodiment of this application;
FIG. 5 is a schematic top view of a structure of a combining apparatus according to an embodiment of this application;
FIG. 6 is a diagram of a structure of a filtering apparatus according to an embodiment of this application;
FIG. 7 is a schematic top view of a partial structure of a filtering apparatus according to an embodiment of this application;
FIG. 8 is a diagram of a structure of a first metal wire according to an embodiment of this application;
FIG. 9 is a diagram of a structure of a second metal wire according to an embodiment of this application;
FIG. 10 is a schematic top view of another partial structure of a filtering apparatus according to an embodiment of this application;
FIG. 11 is a schematic top view of another partial structure of a filtering apparatus according to an embodiment of this application;
FIG. 12 is a schematic top view of another partial structure of a filtering apparatus according to an embodiment of this application;
FIG. 13 is a diagram of a first filtering unit circuit at a layer of a dielectric substrate according to an embodiment of this application;
FIG. 14 is a diagram of a first filtering unit circuit at another layer of a dielectric substrate according to an embodiment of this application; and
FIG. 15 is a schematic top view of another partial structure of a filtering apparatus according to an embodiment of this application.

**Reference numerals:**

| | |
|---|---|
| 01-antenna; | 011-radome; |
| 012-radiating element; | 013-reflection panel; |
| 014-feeding network; | 0141-calibration network; |
| 0142-feeding apparatus; | 0143-combining apparatus; |
| 0144-filtering apparatus; | 02-mounting bracket; |
| 03-antenna adjustment support; | 04-radio frequency processing unit; |
| 05-baseband processing unit; | 06-cable; |
| 1-first general transmission port; | 2-second general transmission port; |
| 31-first filtering unit circuit; | 311-first metal wire; |
| 3111-first coupling region; | 3112-second coupling region; |
| 3113-first connecting region; | 3114-first branch line; |
| 312-second metal wire; | 3121-third coupling region; |
| 3122-fourth coupling region; | 3123-second connecting region; |
| 3124-second branch line; | 313-first transmission line; |
| 314-second transmission line; | 315-first transmission port; |
| 316-second transmission port; | 317-metal via hole; |
| 318-metal layer; | 32-support mechanical part; |
| 321-first surface; | 322-second surface; |
| 33-housing; | 331-opening; |
| 332-groove; | 34-second filtering unit circuit; |
| 341-third metal wire; | 3411-fifth coupling region; |
| 3412-third connecting region; | 3413-third transmission line; |
| 342-fourth metal wire; | 3421-sixth coupling region; |
| 3422-fourth connecting region; and | 3423-fourth transmission line. |

### DESCRIPTION OF EMBODIMENTS

To make the objectives, technical solutions, and advantages of this application clearer, the following further describes this application in detail with reference to the accompanying drawings.

Terms used in the following embodiments are merely intended to describe specific embodiments, but are not intended to limit this application. The terms "one", "a", "the", "the foregoing", and "this" of singular forms used in this specification and the appended claims of this application are also intended to include expressions such as "one or more", unless otherwise specified in the context clearly.

Reference to "an embodiment" or "a specific embodiment" or the like described in the specification means that one or more embodiments of this application include a specific feature, structure, or characteristic described with reference to this embodiment. The terms "include", "have", and their variants all mean "include but are not limited to", unless otherwise specifically emphasized in another manner.

To facilitate understanding of the filtering apparatus, the combining apparatus, the antenna, and the base station provided in embodiments of this application, the following first describes an application scenario of the filtering apparatus, the combining apparatus, the antenna, and the base station.

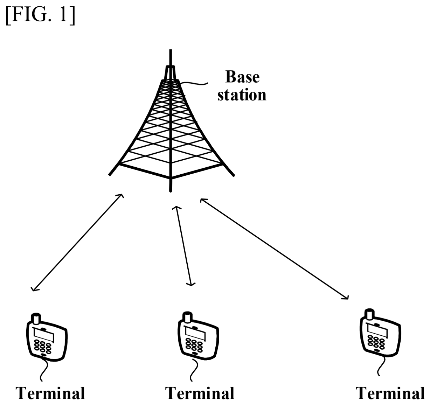

FIG. 1 is a diagram of an architecture of a communication system to which an embodiment of this application is applicable. As shown in FIG. 1, the communication system may be a base station antenna feeder system. The application scenario may include a communication device and a terminal. In this scenario, the communication device may also be referred to as a base station. Wireless communication may be implemented between the base station and the terminal. The base station may be located in a base station subsystem (base station subsystem, BBS), a UMTS terrestrial radio access network (UMTS terrestrial radio access network, UTRAN), or an evolved universal terrestrial radio access network (evolved universal terrestrial radio access network, E-UTRAN), and is configured to perform radio signal cell coverage to implement communication between the terminal device and a wireless network. Specifically, the base station may be a base transceiver station (base transceiver station, BTS) in a global system for mobile communications (global system for mobile communications, GSM) or a code division multiple access (code division multiple access, CDMA) system, may be a NodeB (NodeB, NB) in a wideband code division multiple access (wideband code division multiple access, WCDMA) system, may be an evolved NodeB (evolved NodeB, eNB, or eNodeB) in a long term evolution (long term evolution, LTE) system, or may be a radio controller in a cloud radio access network (cloud radio access network, CRAN) scenario. Alternatively, the base station may be a relay station, an access point, a vehicle-mounted device, a wearable device, a gNodeB (gNodeB or gNB) in a new radio (new radio, NR) system, a base station in a future evolved network, or the like. This is not limited in embodiments of this application.

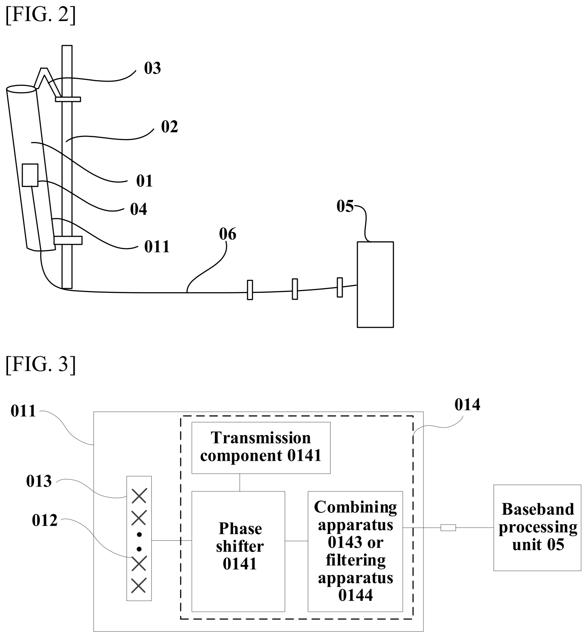

FIG. 2 is a diagram of a possible structure of a base station. As shown in FIG. 2, as a communication device, the base station may generally include structures such as an antenna 01, a mounting bracket 02, and an antenna adjustment support 03. The antenna 01 may include a radome 011. The radome 011 has a good electromagnetic wave penetration characteristic in terms of electrical performance, and can withstand impact of an external harsh environment in terms of mechanical performance, so that the radome can protect the antenna 01 from being affected by an external environment. The antenna 01 may be mounted on the mounting bracket 02 by use of the antenna adjustment support 03, to help the antenna 01 receive or transmit signals. Certainly, the embodiment shown in FIG. 2 is merely used as an optional implementation. During specific implementation, the antenna and the communication device in embodiments of this application may be different from those in the embodiment shown in FIG. 2.

In addition, the communication device may further include a radio frequency processing unit 04 and a baseband processing unit 05. For example, the radio frequency processing unit 04 may be configured to perform frequency selection, amplification, and down-conversion on signals received by the antenna 01, convert the processed signals into intermediate frequency signals or baseband signals, and send the intermediate frequency signals or baseband signals to the baseband processing unit 05; or the radio frequency processing unit 04 is configured to perform up-conversion and amplification on the baseband processing unit 05 or intermediate frequency signals, and the antenna 01 converts the processed signals into electromagnetic waves and sends out the electromagnetic waves. The baseband processing unit 05 may be connected to a feeding network of the antenna 01 through the radio frequency processing unit 04. In some implementations, the radio frequency processing unit 04 may also be referred to as a remote radio unit (remote radio unit, RRU), or may be a radio frequency apparatus in an active antenna unit (active antenna unit, AAU). The baseband processing unit 05 may also be referred to as a baseband unit (baseband unit, BBU).

In a possible embodiment, as shown in FIG. 2, the radio frequency processing unit 04 and the antenna 01 may be integrally disposed, and the baseband processing unit 05 is located at a remote end of the antenna 01. In some other embodiments, both the radio frequency processing unit 04 and the baseband processing unit 05 may be located at a remote end of the antenna 01. The radio frequency processing unit 04 and the baseband processing unit 05 may be connected through a cable 06.

More specifically, refer to FIG. 2 and FIG. 3 together. FIG. 3 is a diagram of a possible composition of an antenna according to an embodiment of this application. As shown in FIG. 3, the antenna 01 of the communication device may include a radiating element 012 and a reflection panel 013. The radiating element 012 may also be referred to as an antenna element, an element, or the like, and can effectively send or receive an antenna signal. For the antenna 01, frequencies of different radiating elements 012 may be the same or different. The reflection panel 013 may also be referred to as a bottom board, an antenna panel, a reflective surface, or the like, and may be made of metal. When the antenna 01 receives signals, the reflection panel 013 may reflect the antenna signals to a target coverage area. When the antenna 01 transmits signals, the reflection panel 013 may reflect signals transmitted to the reflection panel 013, and transmit the signals. The radiating element 012 is usually placed on a surface of a side of the reflection panel 013. This can not only greatly enhance a capability of the antenna 01 of receiving or transmitting signals, but also block and shield interference caused to the antenna's reception of signals by other electric waves that are from a back of the reflection panel 013 (in this application, the back of the reflection panel 013 is a side that is away from the side that is of the reflection panel 013 and on which the radiating element 012 is disposed).

In the antenna 01 of the communication device, the radiating element 012 is connected to the feeding network 014. The feeding network 014 is usually formed by a controlled impedance signal line. The feeding network 014 may feed a signal to the radiating element 012 based on a specific amplitude and a specific phase, or send a received signal to the baseband processing unit 05 of the communication device based on a specific amplitude and a specific phase. Specifically, in some implementations, the feeding network 014 may be used to implement different radiation beam directions, or may be connected to a calibration network 0141 to obtain a calibration signal required by a system. The feeding network 014 may include a feeding apparatus 0142, configured to change a phase of antenna signal radiation. Some modules configured to extend performance may be further disposed in the feeding network 014, for example, a combining apparatus 0143 (which may also be referred to as a combiner). The combining apparatus 0143 is electrically connected to the radiating element 012, and may be configured to combine signals of different frequencies into one channel of signals, to transmit the signals through the antenna 01; or during reverse use, may be configured to split, based on different frequencies, signals received by the antenna 01 into a plurality of channels of signals, to send the signals to the baseband processing unit 05 for processing. For another example, a filtering apparatus 0144 (which may also be referred to as a filter) may be disposed. The filtering apparatus 0144 is electrically connected to the radiating element 012, and may be configured to filter out an interference signal.

It should be noted that embodiments that are related to terms such as "specific", "specifically specified", and "specifically designed" in this application are all optional embodiments. In other words, the embodiment is a possible specific embodiment under the concept of this application, but further includes another possible embodiment.

In addition, this application involves the description of several connection manners, and the connection manners are introduced below. In embodiments of this application, "coupled" means indirect coupling, which may be understood as that two conductors are electrically connected in an air-spaced/non-contact manner. In an embodiment, the indirect coupling may also be referred to as capacitive coupling. For example, signal transmission is implemented by forming an equivalent capacitor through coupling in a gap between two spaced conductive members. In embodiments of this application, "directly electrically connected" may be a form in which two components are physically in contact and are electrically connected, or may be understood as a form in which different components in a line structure are connected through a physical line that can transmit electrical signals, for example, a printed circuit board (printed circuit board, PCB) copper foil or a wire.

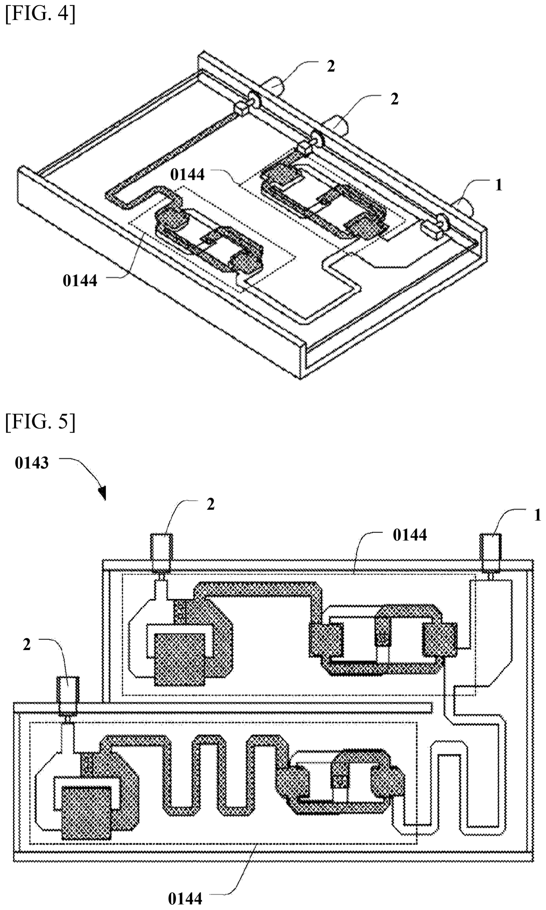

FIG. 4 is a diagram of a structure of a combining apparatus according to an embodiment of this application. FIG. 5 is a schematic top view of a structure of a combining apparatus according to an embodiment of this application. As shown in FIG. 4 and FIG. 5, in an embodiment, the combining apparatus includes a first general transmission port 1, a second general transmission port 2, and at least two filtering apparatuses 0144. One end of each of at least two filtering apparatuses 0144 in all filtering apparatuses 0144 is connected to a same first general transmission port 1, and the other end of each filtering apparatus 0144 is connected to a respective second general transmission port 2, so as to implement signal combination or splitting of the combining apparatus.

For example, the combining apparatus includes a first filtering apparatus and a second filtering apparatus. The combining apparatus includes one first general transmission port 1 and two second general transmission ports 2. One end of the first filtering apparatus is connected to one second general transmission port 2, one end of the second filtering apparatus is connected to the other second general transmission port 2, and the other end of the first filtering apparatus and the other end of the second filtering apparatus are both connected to the first general transmission port 1. In this solution, the second general transmission ports 2 may be used as signal input ports, and the first general transmission port 1 may be used as a signal output port, so as to implement combination of two channels of signals.

During specific operation, a band-pass frequency band of the first filtering apparatus in the foregoing combining apparatus is a first frequency band, and a signal of another frequency band cannot be transmitted through the foregoing first filtering apparatus. A band-pass frequency band of the second filtering apparatus is a second frequency band, and a signal of another frequency band cannot be transmitted through the second filtering apparatus. The combining apparatus can implement combination of signals of the first frequency band and signals of the second frequency band.

In a specific embodiment, a filtering apparatus 0144 may be added to the combining apparatus based on a requirement, to combine signals of more frequency bands. This is not limited in this application.

The first general transmission port 1 and the second general transmission ports 2 may be plug-in interfaces, so as to simplify a connection manner of the combining apparatus.

In addition, if the combining apparatus is used reversely relative to the foregoing embodiment, the combining apparatus may further implement signal splitting. For example, in the foregoing embodiment, the second general transmission ports 2 are used as signal output ports, and the first general transmission port 1 is used as a signal input port, so that splitting of two channels of signals can be implemented. In this case, the combining apparatus may also be referred to as a splitting apparatus.

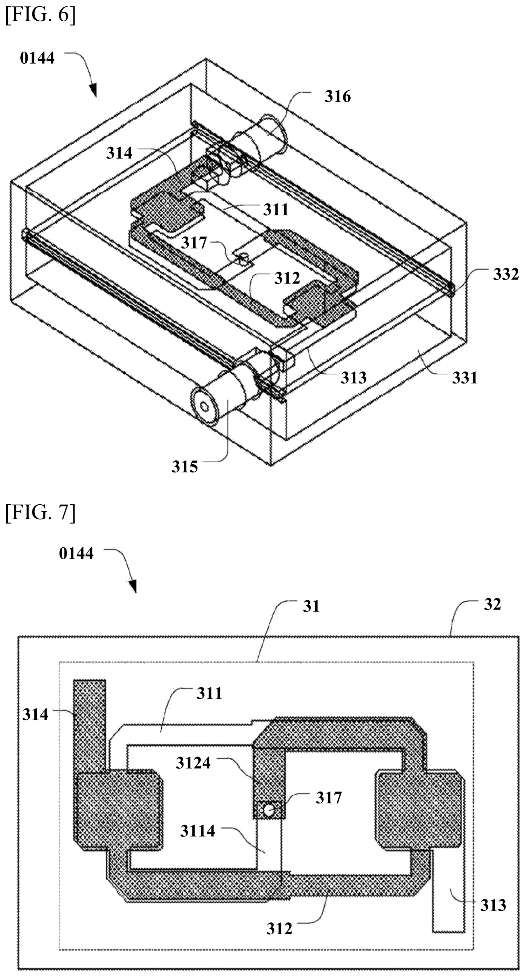

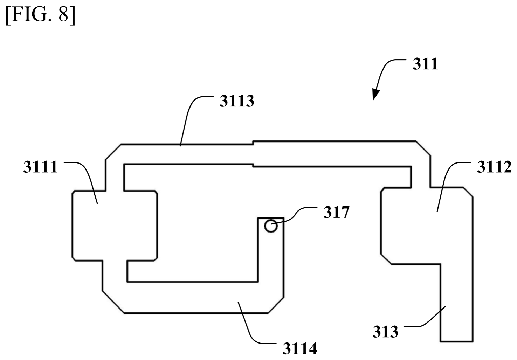

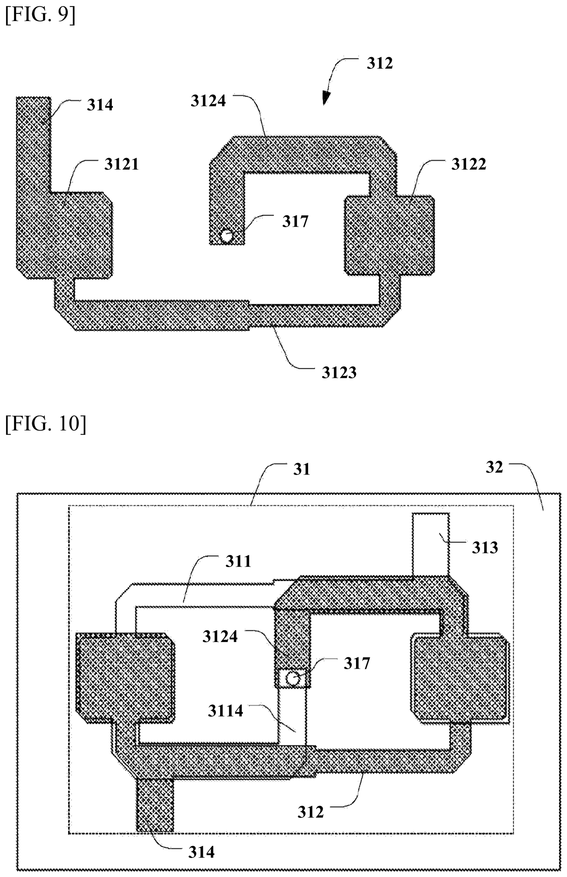

FIG. 6 is a diagram of a structure of a filtering apparatus according to an embodiment of this application. FIG. 7 is a schematic top view of a partial structure of a filtering apparatus according to an embodiment of this application. FIG. 8 is a diagram of a structure of a first metal wire according to an embodiment of this application. FIG. 9 is a diagram of a structure of a second metal wire according to an embodiment of this application. As shown in FIG. 6 to FIG. 9, the filtering apparatus in embodiments of this application includes a first filtering unit circuit 31 and a support mechanical part 32. The first filtering unit circuit 31 is disposed on the support mechanical part 32. The first filtering unit circuit 31 includes a first metal wire 311 and a second metal wire 312. Specifically, the first metal wire 311 includes a first coupling region 3111, a second coupling region 3112, and a first connecting region 3113, and the first connecting region 3113 is connected between the first coupling region 3111 and the second coupling region 3112. Similarly, the second metal wire 312 includes a third coupling region 3121, a fourth coupling region 3122, and a second connecting region 3123, and the second connecting region 3123 is connected between the third coupling region 3121 and the fourth coupling region 3122. An orthographic projection of the first coupling region 3111 on a plane on which a surface of the third coupling region 3121 is located is at least partially located on the surface of the third coupling region 3121. Specifically, the first coupling region 3111 and the second coupling region 3112 are disposed in an overlapping manner, and a gap between the first coupling region 3111 and the third coupling region 3121 is less than a first preset size, so that the first coupling region 3111 and the third coupling region 3121 are coupled. Similarly, an orthographic projection of the second coupling region 3112 on a plane on which a surface of the fourth coupling region 3122 is located is at least partially located on the surface of the fourth coupling region 3122. Specifically, the second coupling region and the fourth coupling region 3122 are disposed in an overlapping manner, and a gap between the second coupling region 3112 and the fourth coupling region 3122 is less than a second preset size, so that the second coupling region 3112 and the fourth coupling region 3122 are coupled. In addition, the first coupling region 3111 is directly electrically connected to the fourth coupling region 3122, the first metal wire 311 is connected to a first transmission line 313, and the second metal wire 312 is connected to a second transmission line 314. The first transmission line 313 and the second transmission line 314 are separately configured to input a signal and output a signal. For example, a signal is input from the first transmission line 313, and is output through the first metal wire 311, the second metal wire 312, and the second transmission line 314; or a signal is input from the second transmission line 314, and is output through the second metal wire 312, the first metal wire 311, and the first transmission line 313. In summary, a signal needs to pass through the first metal wire 311 and the second metal wire 312 for filtering. This is not limited in this application.

The filtering apparatus 0144 in this embodiment has a relatively simple structure and a relatively small size, which is conducive to miniaturization and low costs of the filtering apparatus 0144. In addition, the filtering apparatus 0144 has a relatively small quantity of accessories, and the filtering apparatus 0144 has a relatively small quantity of intermodulation points, so that interference to a signal is relatively small, which helps improve working efficiency of the filtering apparatus 0144.

In a specific embodiment, the first coupling region 3111, the first connecting region 3113, and the second coupling region 3112 of the first metal wire 311 are connected in sequence, so that the first coupling region 3111, the first connecting region 3113, and the second coupling region 3112 are of an integrated structure, and correspond to different regions of the first metal wire 311. Similarly, the third coupling region 3121, the second connecting region 3123, and the fourth coupling region 3122 of the second metal wire 312 are connected in sequence, so that the third coupling region 3121, the second connecting region 3123, and the fourth coupling region 3122 are of an integrated structure, and correspond to different regions of the second metal wire 312.

In a process of forming a combining apparatus with filtering apparatuses 0144 in this embodiment of this application, second metal wires 312 of at least two filtering apparatuses 0144 may be electrically connected to a same first general transmission port 1, and a first metal wire 311 of each filtering apparatus 0144 may be electrically connected to one second general transmission port 2. In a specific embodiment, the combining apparatus includes one first general transmission port 1, at least two second general transmission ports 2, and at least two filtering apparatuses 0144. Second metal wires 312 of all the filtering apparatuses 0144 are connected to the first general transmission port 1, and a first metal wire 311 of each filtering apparatus is electrically connected to one second general transmission port 2. Specifically, the at least two second general transmission ports 2 may be in one-to-one correspondence with the at least two filtering apparatuses.

For the embodiments shown in FIG. 6 and FIG. 7, the filtering apparatus 0144 includes one first filtering unit circuit 31 and two transmission ports, where the two transmission ports are a first transmission port 315 and a second transmission port 316 respectively. A first transmission line 313 of the first filtering unit circuit 31 is connected to the first transmission port 315, so that the first metal wire 311 is connected to the first transmission port 315; and a second transmission line 314 is connected to the second transmission port 316, so that the second metal wire 312 is connected to the second transmission port 316. The first transmission port 315 and the second transmission port 316 are configured to connect to external devices. In this embodiment, filtering may be performed in a form of cascading and self-coupling of metal wires, and an in-band dual-pole and out-of-band dual-zero band-stop filtering effect can be implemented. The filtering apparatus 0144 has a smaller volume compared with a filtering apparatus 0144 with an equivalent function.

Specifically, the foregoing transmission port may be a plug-in interface for plug-in connection with an external device, so as to simplify a connection manner of the filtering apparatus 0144.

Specific values of the first preset size and the second preset size are not limited, and may be selected and designed based on an operating frequency and the like of the filtering apparatus 0144. In addition, the first preset size and the second preset size may be the same or may be different. This is not limited in this application.

In a specific embodiment, neither a formation manner of the first filtering unit circuit 31 nor a structure of the support mechanical part 32 is limited. For example, the first filtering unit circuit 31 may be a sheet-metal microstrip, and the support mechanical part 32 is configured to support the sheet-metal microstrip.

In the embodiments shown in FIG. 6 and FIG. 7, the support mechanical part 32 may be a dielectric substrate, and the first filtering unit circuit 31 may be formed on a surface of or inside the dielectric substrate. In this embodiment of this application, an example in which the first filtering unit circuit 31 is formed on the surface of the dielectric substrate is used to describe the technical solutions of this application.

As shown in FIG. 6 and FIG. 7, an orthographic projection of the first coupling region 3111 on a plane on which the dielectric substrate is located at least partially overlaps an orthographic projection of the third coupling region 3121 on the plane on which the dielectric substrate is located, and a gap between the first coupling region 3111 and the third coupling region 3121 is less than a first preset size, so that the first coupling region 3111 and the third coupling region 3121 are coupled. In addition, an orthographic projection of the second coupling region 3112 on the plane on which the dielectric substrate is located at least partially overlaps an orthographic projection of the fourth coupling region 3122 on the plane on which the dielectric substrate is located, and a gap between the second coupling region 3112 and the fourth coupling region 3122 is less than a second preset size, so that the second coupling region 3112 and the fourth coupling region 3122 are coupled. In this case, the first preset size and the second preset size may be equivalent to a thickness of the dielectric substrate.

With reference to FIG. 6 to FIG. 9, in a specific embodiment, the first metal wire 311 and the second metal wire 312 may be disposed at different layers of the dielectric substrate, to facilitate the following implementation: The orthographic projection of the first coupling region 3111 on the plane on which the dielectric substrate is located at least partially overlaps the orthographic projection of the third coupling region 3121 on the plane on which the dielectric substrate is located, and the gap between the first coupling region 3111 and the third coupling region 3121 is less than the first preset size; in addition, the orthographic projection of the second coupling region 3112 on the plane on which the dielectric substrate is located at least partially overlaps the orthographic projection of the fourth coupling region 3122 on the plane on which the dielectric substrate is located, and the gap between the second coupling region 3112 and the fourth coupling region 3122 is less than the second preset size. In a specific embodiment, the gap between the first coupling region 3111 and the third coupling region 3121 is the same as the gap between the second coupling region 3112 and the fourth coupling region 3122.

In a further embodiment, the first metal wire 311 and the second metal wire 312 may be disposed on surfaces of two sides of the dielectric substrate, which helps simplify a preparation process. In this case, the first preset size and the second preset size may be equivalent to the thickness of the dielectric substrate.

When the first metal wire 311 and the second metal wire 312 are disposed at different layers of the dielectric substrate, the first coupling region 3111 and the fourth coupling region 3122 can be directly electrically connected through a metal via hole 317.

In addition, to implement the electrical connection between the first coupling region 3111 and the fourth coupling region 3122, the first coupling region 3111 may be connected to a first branch line 3114, and the fourth coupling region 3122 may be connected to a second branch line 3124, where the first branch line 3114 and the second branch line 3124 are directly electrically connected. Further, the first branch line 3114 and the second branch line 3124 may be directly electrically connected through the metal via hole 317.

Continue to refer to FIG. 6. In a specific embodiment, the filtering apparatus 0144 may further include a housing 33, where the housing 33 is of an integrated structure. The housing 33 has an inner cavity, and the support mechanical part 32 (which is the dielectric substrate in the figure) is disposed in the inner cavity. To mount the support mechanical part 32, the housing 33 has an opening 331 in communication with the inner cavity. In addition, the inner cavity of the housing 33 has a groove 332, and the groove 332 extends towards the opening 331, so that the support mechanical part 32 can be inserted into the groove 332. In this embodiment, the housing 33 is of an integrated structure. Therefore, the structure of the filtering apparatus 0144 is relatively simple, a quantity of accessories of the filtering apparatus 0144 is relatively small, a quantity of intermodulation points of the filtering apparatus 0144 is also relatively small, and interference to a signal is relatively small, which helps improve working efficiency of the filtering apparatus 0144. In addition, a mounting process of the support mechanical part 32 is relatively simple. The housing 33 has a specific protection effect for the support mechanical part 32 and the first filtering unit circuit 31 disposed on the support mechanical part 32.

In a further embodiment, the housing 33 may be made of a metal material, so that the entire housing 33 made of the metal material may be used as a reference ground of the filtering apparatus 0144. This helps further reduce the quantity of accessories of the filtering apparatus 0144. In addition, in this embodiment, the filtering apparatus 0144 can form a suspended microstrip structure.

In embodiments of this application, a connection position between the first transmission line 313 and the first metal wire 311 is not limited, and a connection position between the second transmission line 314 and the second metal wire 312 is not limited either. Refer to FIG. 6 to FIG. 9. In an embodiment, the first transmission line 313 is directly electrically connected to one end that is of the first coupling region 3111 and that is away from the first connecting region 3113, and the second transmission line 314 is directly electrically connected to one end that is of the fourth coupling region 3122 and that is away from the second connecting region 3123. FIG. 10 is a schematic top view of another partial structure of a filtering apparatus according to an embodiment of this application. As shown in FIG. 10, in another embodiment, the first transmission line 313 is directly electrically connected to the first connecting region 3113, and the second transmission line 314 is directly electrically connected to the second connecting region 3123. Positions of the first transmission line 313 and the second transmission line 314 may be adjusted based on an operating frequency band of the filtering apparatus 0144. Specifically, in this embodiment of this application, the operating frequency band of the filtering apparatus 0144 may be a band-pass frequency band of the filtering apparatus 0144, or may be a band-stop frequency band of the filtering apparatus 0144.

In addition, disposition positions of the first branch line 3114 and the second branch line 3124 are not limited in this application. In an embodiment, in the embodiments shown in FIG. 6 to FIG. 10, an orthographic projection of the first branch line 3114 on a plane on which the dielectric substrate is located at least partially overlaps an orthographic projection of the second connecting region 3123 on the plane on which the dielectric substrate is located, and an orthographic projection of the second branch line 3124 on the plane on which the dielectric substrate is located at least partially overlaps an orthographic projection of the first connecting region 3113 on the plane on which the dielectric substrate is located. In other words, the first branch line and the second connecting region 3123 are stacked, and the second branch line 3124 and the first connecting region 3113 are stacked. Then, electrical connection is implemented in a middle region between the first coupling region 3111 and the second coupling region 3112, so that the first filtering unit circuit 31 is of a symmetric structure as a whole.

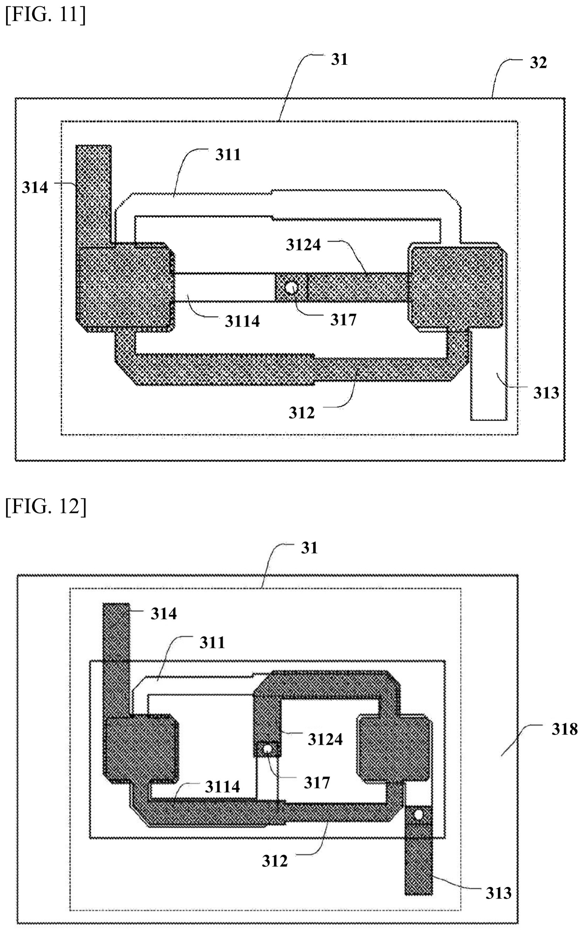

FIG. 11 is a schematic top view of another partial structure of a filtering apparatus according to an embodiment of this application. As shown in FIG. 11, in another embodiment, the first branch line 3114 and the second branch line 3124 may extend along a straight line direction from the first coupling region 3111 to the second coupling region 3112, and are directly electrically connected in a middle region between the first coupling region 3111 and the second coupling region 3112. The first branch line 3114 and the second branch line 3124 extend along a shortest path.

FIG. 12 is a schematic top view of another partial structure of a filtering apparatus according to an embodiment of this application. As shown in FIG. 12, in another embodiment, a metal layer 318 is disposed on a surface of the dielectric substrate, and the metal layer 318 is used as a reference ground of the filtering apparatus 0144. The metal layer 318 is disconnected from the first metal wire 311 and the second metal wire 312. In other words, the metal layer 318 is not electrically connected to the first metal wire 311 or the second metal wire 312. Specifically, the metal layer 318 and the first metal wire 311 or the second metal wire 312 may be disposed at a same layer. Alternatively, the filtering apparatus may further include two metal layers 318, and the two metal layers 318 are respectively disposed at the same layers as the first metal wire 311 and the second metal wire 312. Specifically, a gap may be etched between the first metal wire 311 and the metal layer 318, and a gap may be etched between the second metal wire 312 and the metal layer 318, to enable the metal layer 318 to be disconnected from the first metal wire 311 and the second metal wire 312. In this embodiment, a structure of the reference ground of the filtering apparatus 0144 is simple, and the housing 33 may not be disposed as the reference ground, thereby further reducing the volume of the filtering apparatus 0144. The filtering apparatus 0144 in this embodiment is formed as an air microstrip structure.

In a specific embodiment, the metal layer 318 may be disposed on a surface of one side of the dielectric substrate, or the metal layer 318 may be disposed on surfaces of two sides of the dielectric substrate. This is not limited in this application.

Certainly, in some embodiments, the dielectric substrate having the metal layer 318 may alternatively be mounted inside the housing 33, to protect a circuit structure of the filtering apparatus 0144.

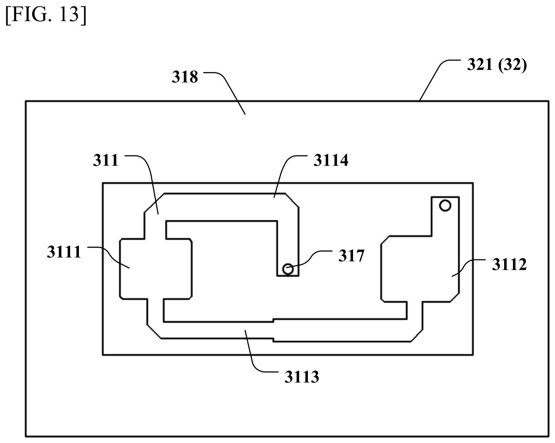

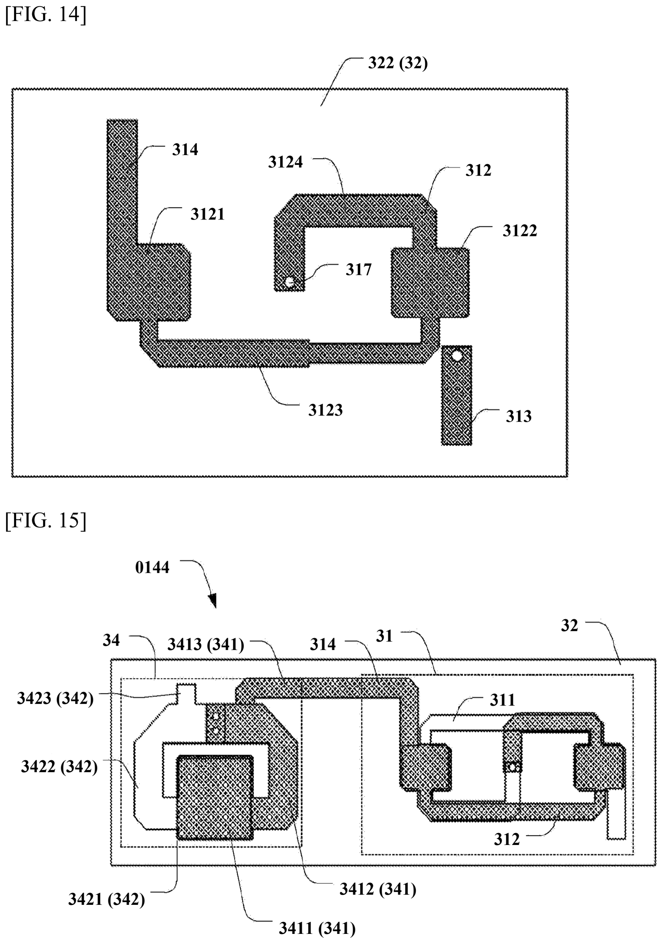

FIG. 13 is a diagram of a first filtering unit circuit at a layer of the dielectric substrate according to an embodiment of this application. FIG. 14 is a diagram of a first filtering unit circuit at another layer of the dielectric substrate according to an embodiment of this application. With reference to FIG. 12 to FIG. 14, in a specific embodiment, the first metal wire 311 and the second metal wire 312 may be respectively disposed on the surfaces of the two sides of the dielectric substrate. Specifically, the dielectric substrate includes a first surface 321 and a second surface 322, the first metal wire 311 and the metal layer 318 are disposed on the first surface 321, and the second metal wire 312 is disposed on the second surface 322. The metal layer 318 and the first metal wire 311 are disposed on a same layer, and are disposed on the same surface of the dielectric substrate. To implement disconnection between the first metal wire 311 and the metal layer 318, and prevent the first metal wire 311 from being connected to the metal layer 318, the first transmission line 313 may be disposed on a surface of a side on which the second metal wire 312 is located, that is, the first transmission line 313 is disposed on the second surface 322, and then the first transmission line 313 is electrically connected to the first metal wire 311 through a metal via hole. In this solution, the first transmission line 313 and the second transmission line 314 may be further located at a same layer, to facilitate connection to an external device or a transmission port.

Continue to refer to FIG. 6 to FIG. 14. In a specific embodiment, the first coupling region 3111, the second coupling region 3112, the third coupling region 3121, and the fourth coupling region 3122 are sheet-shaped, and the first connector and the second connecting region 3123 are line-shaped. That is, the coupling regions and the connecting regions have different widths. The first coupling region 3111, the second coupling region 3112, the third coupling region 3121, and the fourth coupling region 3122 that are sheet-shaped have low impedance, and the first connector and the second connecting region 3123 that are line-shaped have high impedance. This solution uses a form of cascading and self-coupling of double high&low metal wires, and achieves an in-band double-pole and out-of-band double-zero band-stop filtering effect. In addition, the first coupling region 3111, the second coupling region 3112, the third coupling region 3121, and the fourth coupling region 3122 that are sheet-shaped have a relatively large coupling area and a good coupling effect, so that the volume of the filtering apparatus 0144 can be relatively small.

Specifically, an extension direction of the first metal wire 311 after being spread is used as a length direction, and a direction perpendicular to the length direction is used as a width direction. In this case, widths of the first coupling region 3111 and the second coupling region 3112 in the width direction are greater than a width of the first connecting region 3113 in the width direction. Similarly, widths of the third coupling region 3121 and the fourth coupling region 3122 in the width direction are greater than a width of the first connecting region 3113 in the width direction.

In addition, in another embodiment, the widths of the first coupling region 3111 and the second coupling region 3112 in the width direction are equal to the width of the first connecting region 3113 in the width direction. Similarly, the widths of the third coupling region 3121 and the fourth coupling region 3122 in the width direction are equal to the width of the first connecting region 3113 in the width direction. It may be understood that the foregoing equality is not complete equality in a mathematical sense. Specifically, a preparation tolerance may be accommodated, and the foregoing widths are approximately equal.

Specifically, the widths of the first coupling region 3111, the second coupling region 3112, the first connecting region 3113, the third coupling region 3121, the fourth coupling region 3122, and the second connecting region 3123 in the width direction affect an operating frequency band of the filtering apparatus 0144. Specifically, proper widths of the foregoing parts may be designed based on an actual requirement.

In a further embodiment, shapes of the first coupling region 3111, the second coupling region 3112, the third coupling region 3121, and the fourth coupling region 3122 are not limited. In an embodiment, the first coupling region 3111 and the third coupling region 3121 have a same shape, and the second coupling region 3112 and the fourth coupling region 3122 have a same shape. Specifically, a shape of the orthographic projection of the first coupling region 3111 on the plane on which the surface of the third coupling region 3121 is located may be the same as a shape of the surface of the third coupling region 3121, and a shape of the orthographic projection of the second coupling region 3112 on the plane on which the surface of the fourth coupling region 3122 is located may be the same as a shape of the surface of the fourth coupling region 3122. Specifically, in a process of forming the first metal wire 311 and the second metal wire 312 on the dielectric substrate, a shape of a surface that is of the first coupling region 3111 and that faces the third coupling region 3121 is the same as a shape of a surface that is of the third coupling region 3121 and that faces the first coupling region 3111, and a shape of a surface that is of the second coupling region 3112 and that faces the fourth coupling region 3122 is the same as a shape of a surface that is of the fourth coupling region 3122 and that faces the second coupling region 3112. In this way, when the first coupling region 3111 is coupled to the third coupling region 3121, a coupling area of the first coupling region 3111 and the third coupling region 3121 may be an area of the foregoing surface of the first coupling region 3111. Similarly, when the second coupling region 3112 is coupled to the fourth coupling region 3122, a coupling area of the second coupling region 3112 and the fourth coupling region 3122 may be an area of the foregoing surface of the second coupling region 3112. This solution helps fully couple the first coupling region 3111 and the third coupling region 3121 and fully utilize the areas of the first coupling region 3111 and the third coupling region 3121. Similarly, this also helps fully couple the second coupling region 3112 and the fourth coupling region 3122 and fully utilize the areas of the second coupling region 3112 and the fourth coupling region 3122.

In addition, shapes of the first coupling region 3111, the second coupling region 3112, the third coupling region 3121, and the fourth coupling region 3122 may be regular shapes such as squares or circles, which are convenient for preparation and simulation analysis, so as to determine an operating frequency band. Alternatively, the shapes may be irregular shapes. This is not limited in this application.

To enable the first coupling region 3111 and the third coupling region 3121 to be fully coupled, the orthographic projection of the first coupling region 3111 on the plane on which the surface of the third coupling region 3121 is located may be completely located on the surface of the third coupling region 3121. In this case, a coupling area of the first coupling region 3111 and the third coupling region 3121 is approximately an area of the first coupling region 3111. Alternatively, in another embodiment, an orthographic projection of the third coupling region 3121 on a plane on which the surface of the first coupling region 3111 is located may be completely located on the surface of the first coupling region 3111. In this case, a coupling area of the first coupling region 3111 and the third coupling region 3121 is approximately an area of the third coupling region 3121.

When the support mechanical part 32 is the dielectric substrate, the orthographic projection of the first coupling region 3111 on the plane on which the dielectric substrate is located completely covers the orthographic projection of the third coupling region 3121 on the plane on which the dielectric substrate is located. Alternatively, the orthographic projection of the third coupling region 3121 on the plane on which the dielectric substrate is located completely covers the orthographic projection of the first coupling region 3111 on the plane on which the dielectric substrate is located. That is, at least one of the first coupling region 3111 and the third coupling region 3121 completely covers the other, and a coupling area of the two is an area of one of the two coupling regions with a smaller area.

Similarly, to enable the second coupling region 3112 and the fourth coupling region 3122 to be fully coupled, the orthographic projection of the second coupling region 3112 on the plane on which the surface of the fourth coupling region 3122 is located may be completely located on the surface of the fourth coupling region 3122. In this case, a coupling area of the second coupling region 3112 and the fourth coupling region 3122 is approximately an area of the second coupling region 3112. Alternatively, in another embodiment, an orthographic projection of the fourth coupling region 3122 on a plane on which the surface of the second coupling region 3112 is located may be completely located on the surface of the second coupling region 3112. In this case, a coupling area of the second coupling region 3112 and the fourth coupling region 3122 is approximately an area of the fourth coupling region 3122.

When the support mechanical part 32 is the dielectric substrate, the orthographic projection of the second coupling region 3112 on the plane on which the dielectric substrate is located completely covers the orthographic projection of the fourth coupling region 3122 on the plane on which the dielectric substrate is located. Alternatively, the orthographic projection of the fourth coupling region 3122 on the plane on which the dielectric substrate is located completely covers the orthographic projection of the second coupling region 3112 on the plane on which the dielectric substrate is located. That is, at least one of the second coupling region 3112 and the fourth coupling region 3122 completely covers the other, and a coupling area of the two is an area of one of the two coupling regions with a smaller area.

In a further embodiment, the area of the first coupling region 3111 may be greater than the area of the third coupling region 3121, or the area of the third coupling region 3121 may be greater than the area of the first coupling region 3111; and the area of the second coupling region 3112 may be greater than the area of the fourth coupling region 3122, or the area of the fourth coupling region 3122 may be greater than the area of the second coupling region 3112. This solution is beneficial for absorbing manufacturing tolerances and ensures a coupling area of the coupling regions.

FIG. 15 is a schematic top view of another partial structure of a filtering apparatus according to an embodiment of this application. As shown in FIG. 15, in another embodiment, the filtering apparatus 0144 further includes a second filtering unit circuit 34. The second filtering unit circuit 34 includes a third metal wire 341 and a fourth metal wire 342, and the third metal wire 341 and the fourth metal wire 342 are also disposed on the dielectric substrate. The third metal wire 341 includes a fifth coupling region 3411 and a third connecting region 3412, and the fifth coupling region 3411 is connected to the third connecting region 3412. The fourth metal wire 342 includes a sixth coupling region 3421 and a fourth connecting region 3422, and the sixth coupling region 3421 is connected to the fourth connecting region 3422. An orthographic projection of the fifth coupling region 3411 on a plane on which a surface of the sixth coupling region 3421 is located is at least partially located on the surface of the sixth coupling region 3421, and a gap between the fifth coupling region 3411 and the sixth coupling region 3421 is less than a third preset size, so that the fifth coupling region 3411 and the sixth coupling region 3421 are coupled. When the support mechanical part 32 is the dielectric substrate, it may be further considered that an orthographic projection of the fifth coupling region 3411 on the plane on which the dielectric substrate is located at least partially overlaps an orthographic projection of the sixth coupling region 3421 on the plane on which the dielectric substrate is located. One end that is of the third connecting region 3412 and that is away from the fifth coupling region 3411 is directly electrically connected to one end that is of the fourth connecting region 3422 and that is away from the sixth coupling region 3421. The third metal wire 341 is directly electrically connected to the second metal wire 312, so that the first filtering unit circuit 31 and the second filtering unit circuit 34 work together. In a specific embodiment, the third metal wire 341 is connected to a third transmission line 3413, the fourth metal wire 342 is connected to a fourth transmission line 3423, and the third transmission line 3413 is directly electrically connected to the second transmission line 314. The first transmission line 313 is connected to the first transmission port, and the fourth transmission line 3423 is connected to the second transmission port.

In a specific embodiment shown in FIG. 15, when the filtering apparatus 0144 includes one first filtering unit circuit 31 and one second filtering unit circuit 34, the second transmission line 314 is connected to a transmission port of the filtering apparatus 0144, and the fourth transmission line 3423 is connected to another transmission port of the filtering apparatus 0144. The filtering apparatus 0144 in this embodiment performs filtering in a form of cascading and self-coupling of metal wires, can implement an in-band three-pole and out-of-band three-zero band-stop filtering effect, and has a smaller volume compared with a filtering apparatus 0144 with an equivalent function.

In another embodiment, the filtering apparatus includes at least two first filtering unit circuits, first transmission lines of two adjacent filtering unit circuits are directly electrically connected, and/or second transmission lines of two adjacent first filtering unit circuits are directly electrically connected. When the filtering apparatus includes two first filtering unit circuits, two adjacent first transmission lines may be electrically connected, and two second transmission lines are respectively connected to two transmission ports of the filtering apparatus. When the filtering apparatus includes three first filtering unit circuits, the three first filtering unit circuits are sequentially a first filtering unit circuit A, a first filtering unit circuit B, and a first filtering unit circuit C based on a connection sequence. A first metal wire of the first filtering unit circuit A is directly electrically connected to a transmission port of the filtering apparatus, a second metal wire of the first filtering unit circuit A is directly electrically connected to a second metal wire of the first filtering unit circuit B, a first metal wire of the first filtering unit circuit B is directly electrically connected to a first metal wire of the first filtering unit circuit C, and a second metal wire of the first filtering unit circuit C is directly electrically connected to another transmission port of the filtering apparatus. In a specific embodiment, when the support mechanical part of the filtering apparatus is a dielectric substrate, metal wires that are located at a same layer and that are in adjacent first filtering unit circuits may be directly electrically connected.

Specifically, a proper quantity of first filtering unit circuits and a proper quantity of second filtering unit circuits are selected based on a requirement, to form a multi-order filtering apparatus. For example, when the filtering apparatus includes two first filtering unit circuits, an in-band four-pole and out-of-band four-zero band-stop filtering effect can be implemented; or when the filtering apparatus includes three first filtering unit circuits, an in-band six-pole and out-of-band six-zero band-stop filtering effect can be implemented, and the filtering apparatus has a smaller volume compared with a filtering apparatus with an equivalent function.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A filtering apparatus, comprising a first filtering unit circuit and a support mechanical part, wherein the first filtering unit circuit is disposed on the support mechanical part, and the first filtering unit circuit comprises a first metal wire and a second metal wire;
the first metal wire comprises a first coupling region, a second coupling region, and a first connecting region, and the first connecting region is connected between the first coupling region and the second coupling region; the second metal wire comprises a third coupling region, a fourth coupling region, and a second connecting region, and the second connecting region is connected between the third coupling region and the fourth coupling region;
an orthographic projection of the first coupling region on a plane on which a surface of the third coupling region is located is at least partially located on the surface of the third coupling region, and the first coupling region is coupled to the third coupling region; an orthographic projection of the second coupling region on a plane on which a surface of the fourth coupling region is located is at least partially located on the surface of the fourth coupling region, and the second coupling region is coupled to the fourth coupling region; and
the first coupling region is directly electrically connected to the fourth coupling region.

2. The filtering apparatus according to claim 1, further comprising a housing, wherein the housing is of an integrated structure, the housing has an inner cavity and an opening in communication with the inner cavity, a groove is disposed in the inner cavity of the housing, the groove extends towards the opening, and the support mechanical part is inserted into the groove.

3. The filtering apparatus according to claim 1 or 2, wherein the support mechanical part is a dielectric substrate, an orthographic projection of the first coupling region on a plane on which the dielectric substrate is located at least partially overlaps an orthographic projection of the third coupling region on the plane on which the dielectric substrate is located, and an orthographic projection of the second coupling region on the plane on which the dielectric substrate is located at least partially overlaps an orthographic projection of the fourth coupling region on the plane on which the dielectric substrate is located.

4. The filtering apparatus according to claim 3, wherein a metal layer is disposed on a surface of the dielectric substrate, and the metal layer is disconnected from the first metal wire and the second metal wire.

5. The filtering apparatus according to any one of claims 1 to 4, wherein the first metal wire is connected to a first transmission port, and the second metal wire is connected to a second transmission port.

6. The filtering apparatus according to any one of claims 1 to 5, wherein the first coupling region, the second coupling region, the third coupling region, and the fourth coupling region are sheet-shaped, and the first connector and the second connecting region are line-shaped.

7. The filtering apparatus according to any one of claims 1 to 6, wherein a shape of the orthographic projection of the first coupling region on the plane on which the surface of the third coupling region is located is the same as a shape of the surface of the third coupling region, and a shape of the orthographic projection of the second coupling region on the plane on which the surface of the fourth coupling region is located is the same as a shape of the surface of the fourth coupling region.

8. The filtering apparatus according to any one of claims 1 to 7, wherein the orthographic projection of the first coupling region on the plane on which the surface of the third coupling region is located is completely located on the surface of the third coupling region; and
the orthographic projection of the second coupling region on the plane on which the surface of the fourth coupling region is located is completely located on the surface of the fourth coupling region.

9. The filtering apparatus according to any one of claims 1 to 8, further comprising a second filtering unit circuit, wherein the second filtering unit circuit comprises a third metal wire and a fourth metal wire, the third metal wire comprises a fifth coupling region and a third connecting region that are connected, and the fourth metal wire comprises a sixth coupling region and a fourth connecting region that are connected;
an orthographic projection of the fifth coupling region on a plane on which a surface of the sixth coupling region is located is at least partially located on the surface of the sixth coupling region, and the fifth coupling region is coupled to the sixth coupling region;
one end that is of the third connecting region and that is away from the fifth coupling region is directly electrically connected to one end that is of the fourth connecting region and that is away from the sixth coupling region; and
the third metal wire is directly electrically connected to the second metal wire.

10. The filtering apparatus according to any one of claims 1 to 8, comprising at least two first filtering unit circuits, wherein the first metal wires of two adjacent first filtering unit circuits are directly electrically connected, or the second metal wires of two adjacent filtering unit circuits are directly electrically connected.

11. A combining apparatus, comprising one first general transmission port, at least two second general transmission ports, and at least two filtering apparatuses according to any one of claims 1 to 10, wherein the second metal wires of the at least two filtering apparatuses are electrically connected to the first general transmission port, and the first metal wire of each of the filtering apparatuses is electrically connected to one of the second general transmission ports.

12. An antenna, comprising a radiating element and the filtering apparatus according to any one of claims 1 to 10, wherein the filtering apparatus is electrically connected to the radiating element.

13. An antenna, comprising a radiating element and the combining apparatus according to claim 11, wherein the combining apparatus is electrically connected to the radiating element.

14. A base station, comprising a mounting bracket and the antenna according to claim 12 or 13, wherein the antenna is mounted on the mounting bracket.
